# EUROPEAN PATENT APPLICATION

(11) **EP 4 597 547 A1**
(43) Date of publication of application: **06.08.2025**
(21) Application number: 23871766.4
(22) Date of filing: 05.09.2023
(51) Int. Cl.: H01L 21/312, B05D 7/00, B05D 7/24, C23C 16/40, C23C 26/00, H01L 21/304, H01L 21/316

(54) **CHEMICAL SOLUTION, METHOD FOR PRODUCING MODIFIED SUBSTRATE, AND METHOD FOR PRODUCING LAYERED BODY**

(30) Priority: 30.09.2022 JP 2022157867
(71) Applicant: FUJIFILM Corporation, Tokyo 106-8620 (JP)
(72) Inventor: SATO, Koichi, Haibara-gun, Shizuoka 421-0396 (JP); MIZUTANI, Atsushi, Haibara-gun, Shizuoka 421-0396 (JP); HAKAMATA, Akihiro, Haibara-gun, Shizuoka 421-0396 (JP)
(74) Representative: HGF
(86) International application number: PCT/JP2023/032336
(87) International publication number: WO 2024/070526

(57) **Abstract**

Provided is a chemical liquid capable of forming a coating film in which the deposition of a material by an ALD treatment is suppressed. The chemical liquid according to the present invention is a chemical liquid used for manufacturing a semiconductor, including a silylation agent, an aprotic solvent, and an alcohol, in which a content of the alcohol is 5 to 200 ppm by mass with respect to a total mass of the chemical liquid.

## Description

### BACKGROUND OF THE INVENTION

### 1. Field of the Invention

The present invention relates to a chemical liquid, a manufacturing method of a modified substrate, and a manufacturing method of a laminate.

### 2. Description of the Related Art

With further miniaturization of semiconductor devices, there is a demand for the formation of finer and more precise semiconductor elements. In the related art, photolithography has been used in the formation of a semiconductor element, but this method is no longer able to satisfy the accuracy required in recent years due to an error in the alignment of a pattern and the like.

Therefore, as the method for forming a semiconductor element, a method has been studied in which, utilizing selective adsorption of a compound to a region formed of a specific material, a film consisting of such a compound is selectively formed, and the film is then used to treat a region other than the specific material.

Specifically, for example, a method has been devised in which a coating film that inhibits the deposition of a material is selectively formed on a specific region, and then an atomic layer deposition (ALD) treatment is carried out to selectively deposit a material in a region where the coating film is not present.

As a chemical liquid capable of forming the coating film as described above, JP2012-178431A discloses a chemical liquid for forming a water-repellent protective film, which contains a specific silicon compound as a water-repellent protective film forming agent.

### SUMMARY OF THE INVENTION

In a case where a coating film was formed using the chemical liquid described in the above-mentioned document and a material was deposited on the coating film by an ALD treatment, it was found that a large amount of material was deposited on the coating film, indicating a need for improvement.

Therefore, an object of the present invention is to provide a chemical liquid capable of forming a coating film in which the deposition of a material by an ALD treatment is suppressed. In addition, another object of the present invention is to provide a manufacturing method of a modified substrate and a manufacturing method of a laminate, which use the above-mentioned chemical liquid.

As a result of extensive studies to achieve the above-mentioned objects, the present inventors have found that the objects can be achieved by the following configurations.
[1] A chemical liquid used for manufacturing a semiconductor, comprising: a silylation agent; an aprotic solvent; and an alcohol, in which a content of the alcohol is 5 to 200 ppm by mass with respect to a total mass of the chemical liquid.
[2] The chemical liquid according to [1], in which the silylation agent contains a compound having a Si-N bond.
[3] The chemical liquid according to [1] or [2], in which the silylation agent contains a silazane compound or a compound represented by Formula (1) which will be described later.
[4] The chemical liquid according to any one of [1] to [3], in which the silylation agent contains a silazane compound.
[5] The chemical liquid according to any one of [1] to [4], in which the chemical liquid further contains water, and a content of the water is 100 ppm by mass or less with respect to the total mass of the chemical liquid.
[6] The chemical liquid according to any one of [1] to [5], in which the alcohol has 10 or less carbon atoms.
[7] The chemical liquid according to any one of [1] to [6], in which the alcohol has two or more hydroxyl groups.
[8] The chemical liquid according to any one of [1] to [7], in which the content of the alcohol is 5 to 150 ppm by mass with respect to the total mass of the chemical liquid.
[9] A chemical liquid used for manufacturing a semiconductor, comprising: a compound selected from the group consisting of a silazane compound, a compound represented by Formula (1) which will be described later, and an alkoxysilane compound; an aprotic solvent; and an alcohol, in which a content of the alcohol is 5 to 200 ppm by mass with respect to a total mass of the chemical liquid.
[10] The chemical liquid according to any one of [1] to [9], in which the chemical liquid is used in treating a substrate having, on a surface, at least two regions made of different materials.
[11] A manufacturing method of a modified substrate, comprising: a step 1 of bringing a substrate having a region made of an insulator into contact with the chemical liquid according to any one of [1] to [10] to form a coating film containing silicon atoms on the region made of an insulator.
[12] The manufacturing method of a modified substrate according to [11], in which the insulator is a metal oxide.
[13] The manufacturing method of a modified substrate according to [11] or [12], further comprising: a step 2 of carrying out a rinsing treatment on the substrate having the coating film containing silicon atoms after the step 1.
[14] A manufacturing method of a laminate, comprising: a step 3 of subjecting a modified substrate manufactured by the manufacturing method according to any one of [11] to [13] to an atomic layer deposition treatment to form a metal film, a metal oxide film, or a metal nitride film on a region other than a region where the coating film containing silicon atoms is formed.
[15] The manufacturing method of a laminate according to [14], further comprising: a step 4 of removing the coating film containing silicon atoms after the step 3.

According to the present invention, it is possible to provide a chemical liquid capable of forming a coating film in which the deposition of a material by an ALD treatment is suppressed. In addition, according to the present invention, it is also possible to provide a manufacturing method of a modified substrate and a manufacturing method of a laminate, which use the above-mentioned chemical liquid.

### DESCRIPTION OF THE PREFERRED EMBODIMENTS

Hereinafter, the present invention will be described in more detail.

The description of the configuration requirements described below may be made based on the representative embodiments of the present invention, but the present invention is not limited to those embodiments.

In the present specification, any numerical range expressed using "to" means a range that includes the numerical values written before and after "to" as the lower limit value and the upper limit value, respectively.

In the present specification, "ppm" means "parts-per-million (10⁻⁶)", "ppb" means "parts-per-billion (10⁻⁹)", and "ppt" means "parts-per-trillion (10⁻¹²)".

In the present specification, in a case where two or more types of a certain component are present, the "content" of the component means a total content of the two or more types of components.

In the present specification, in a case where there are a plurality of substituents, linking groups, and the like (hereinafter, referred to as substituents and the like) represented by specific reference numerals, or a case where a plurality of substituents and the like are simultaneously specified, it means that the respective substituents and the like may be the same as or different from each other. The same applies to the definition of the number of substituents and the like.

### [Chemical liquid]

Hereinafter, the chemical liquid according to an embodiment of the present invention will be described in more detail.

The chemical liquid according to a first aspect of the present invention is a chemical liquid used for manufacturing a semiconductor, including a silylation agent, an aprotic solvent, and an alcohol, in which a content of the alcohol is 5 to 200 ppm by mass with respect to a total mass of the chemical liquid.

The chemical liquid according to a second aspect of the present invention is a chemical liquid used for manufacturing a semiconductor, including a compound selected from the group consisting of a silazane compound, a compound represented by Formula (1) which will be described later, and an alkoxysilane compound (hereinafter, also referred to as a "specific silicon compound"), an aprotic solvent, and an alcohol, in which a content of the alcohol is 5 to 200 ppm by mass with respect to a total mass of the chemical liquid.

In the present specification, in a case where the term "chemical liquid according to the embodiment of the present invention" is used simply, it is a concept including both the chemical liquid according to the first aspect and the chemical liquid according to the second aspect, unless otherwise specified.

Although the reason why the chemical liquid having the above-mentioned configuration can achieve the objects of the present invention is not always clear, the present inventors speculate as follows.

The mechanism by which the effect is obtained is not limited by the following speculation. In other words, even in a case where the effect is obtained by a mechanism other than the one described below, it is still included within the scope of the present invention.

As the hydrophobicity of a surface of a material is higher, the deposition of the material by an ALD treatment can be suppressed. The silylation agent or specific silicon compound contained in the chemical liquid reacts with a functional group present on a surface of a target on which a coating film is to be formed (hereinafter, also referred to as a "substrate to be modified"), forming a coating film containing silicon atoms that are highly hydrophobic. In this case, since the content of the alcohol in the chemical liquid is equal to or less than a specific amount, the silylation agent or specific silicon compound can form a coating film without being deactivated by a reaction with the alcohol, and thus a hydrophobic film can be formed with a high coverage.

Furthermore, in a case of containing a specific amount or more of the alcohol, a coating film can be formed in a region where a coating film made of the silylation agent or specific silicon compound has not been formed, through interaction between the alcohol and the substrate to be modified. This makes it possible to suppress the deposition of the material having the region where the coating film made of the silylation agent or specific silicon compound has not been formed as a nucleus.

As a result, it is considered that the chemical liquid according to the embodiment of the present invention can form a coating film in which the deposition of a material by an ALD treatment is suppressed.

Hereinafter, the chemical liquid according to the embodiment of the present invention is also simply referred to as a "chemical liquid". In addition, the fact that the deposition of a material by an ALD treatment can be further suppressed is also referred to as "the effect of the present invention is more excellent".

### [Silylation agent]

The chemical liquid according to the first aspect of the present invention contains a silylation agent.

The silylation agent is a compound capable of reacting with a functional group present on a surface of a substrate to be modified to introduce a silyl group. Examples of the functional group include a hydroxyl group, an amino group, a carboxy group, and an amide group.

Examples of the silylation agent include a compound having a Si-N bond and a silylation agent represented by Formula (3) which will be described later.

### <Compound having Si-N bond>

The silylation agent preferably has a Si-N bond. That is, the silylation agent is preferably a compound having a Si-N bond.

The number of Si-N bonds in the compound having a Si-N bond is preferably 1 to 4, more preferably 2 or 3, and still more preferably 2.

The number of carbon atoms in the compound having a Si-N bond is not particularly limited, and is preferably 1 to 25, more preferably 2 to 15, and still more preferably 3 to 12.

Examples of the compound having a Si-N bond include a compound represented by Formula (1) and a silazane compound.

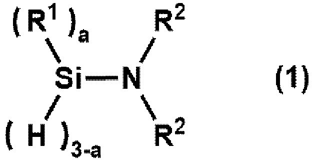

In Formula (1), R¹'s each independently represent a hydrocarbon group (monovalent hydrocarbon group) which may have a halogen atom.

The number of carbon atoms in the hydrocarbon group is preferably 1 to 25.

Examples of the hydrocarbon group include an alkyl group, an alkenyl group, and an aryl group.

The alkyl group may be linear, branched, or cyclic, and is preferably linear. The number of carbon atoms in a linear or branched alkyl group is preferably 1 to 18, more preferably 1 to 6, still more preferably 1 to 4, and particularly preferably 1 or 2. Examples of the linear or branched alkyl group include a methyl group, an ethyl group, an n-propyl group, an isopropyl group, a butyl group, a sec-butyl group, a t-butyl group, an n-hexyl group, an n-hexyl group, an n-heptyl group, an n-octyl group, an n-nonyl group, and an n-decyl group, among which a methyl group, an ethyl group, an n-propyl group, an n-butyl group, or a t-butyl group is preferable, and a methyl group or an ethyl group is more preferable.

The number of carbon atoms in a cyclic alkyl group (cycloalkyl group) is preferably 3 to 18, more preferably 3 to 12, and still more preferably 3 to 6. Examples of the cycloalkyl group include a cyclopropyl group and a cyclohexyl group.

The number of carbon atoms in the alkenyl group is preferably 2 to 12, more preferably 2 to 6, and still more preferably 2 to 4. Examples of the alkenyl group include a vinyl group and an allyl group.

The number of carbon atoms in the aryl group is preferably 5 to 8 and more preferably 5 or 6. Examples of the aryl group include a phenyl group.

Examples of the halogen atom which may be contained in the monovalent hydrocarbon group include a fluorine atom, a chlorine atom, a bromine atom, and an iodine atom, among which a fluorine atom is preferable. In a case where the monovalent hydrocarbon group has a halogen atom, for example, the alkyl group may be a perfluoroalkyl group.

The group represented by R¹ is preferably an alkyl group having 1 to 25 carbon atoms which may have a halogen atom, more preferably a linear alkyl group having 1 to 18 carbon atoms which may have a halogen atom, and still more preferably a linear alkyl group having 1 to 6 carbon atoms which may have a halogen atom.

In a case where a plurality of R¹'s are present, the groups represented by the plurality of R¹'s may be the same as or different from each other.

R²'s each independently represent a hydrogen atom, a hydrocarbon group which may have a halogen atom, or an acyl group (R-CO-. R represents a hydrocarbon group which may have a halogen atom) which may have a halogen atom.

The number of carbon atoms in the hydrocarbon group is preferably 1 to 18.

Examples of the hydrocarbon group include an alkyl group and an aryl group.

The alkyl group may be any of linear, branched, or cyclic. The number of carbon atoms in a linear or branched alkyl group is preferably 1 to 6, more preferably 1 to 4, and still more preferably 1 or 2. Examples of the linear or branched alkyl group include a methyl group, an ethyl group, an n-propyl group, an isopropyl group, a butyl group, a sec-butyl group, a t-butyl group, an n-hexyl group, an n-hexyl group, an n-heptyl group, an n-octyl group, an n-nonyl group, and an n-decyl group, among which a methyl group, an ethyl group, an n-propyl group, or an n-butyl group is preferable, and a methyl group or an ethyl group is more preferable.

The number of carbon atoms in a cyclic alkyl group (cycloalkyl group) is preferably 3 to 12 and more preferably 3 to 6. Examples of the cycloalkyl group include a cyclopropyl group and a cyclohexyl group.

The number of carbon atoms in the aryl group is preferably 5 to 8 and more preferably 5 or 6. Examples of the aryl group include a phenyl group.

Examples of the halogen atom which may be contained in the hydrocarbon group include a fluorine atom, a chlorine atom, a bromine atom, and an iodine atom, among which a fluorine atom is preferable. In a case where the monovalent hydrocarbon group has a halogen atom, for example, the alkyl group may be a perfluoroalkyl group.

The definition and suitable aspects of the hydrocarbon group which may have a halogen atom which is contained in the acyl group are the same as those of the hydrocarbon group which may have a halogen atom, which is represented by R² described above.

The group represented by R² is preferably a hydrogen atom, an alkyl group having 1 to 4 carbon atoms which may have a halogen atom, or an acyl group having 2 to 4 carbon atoms which may have a halogen atom, more preferably a hydrogen atom or an alkyl group having 1 to 4 carbon atoms, and still more preferably a hydrogen atom or a methyl group.

A plurality of groups represented by R² may be the same as or different from each other.

a represents an integer of 1 to 3 and is preferably 2 or 3 and more preferably 3.

Examples of the compound represented by Formula (1) include alkyldimethyl(dimethylamino)silanes such as C₄H₉(CH₃)₂SiN(CH₃)₂, C₅H₁₁(CH₃)₂SiN(CH₃)₂, C₆H₁₃(CH₃)₂SiN(CH₃)₂, C₇H₁₅(CH₃)₂SiN(CH₃)₂, C₈H₁₇(CH₃)₂SiN(CH₃)₂, C₉H₁₉(CH₃)₂SiN(CH₃)₂, C₁₀H₂₁(CH₃)₂SiN(CH₃)₂, C₁₁H₂₃(CH₃)₂SiN(CH₃)₂, C₁₂H₂₅(CH₃)₂SiN(CH₃)₂, C₁₃H₂₇(CH₃)₂SiN(CH₃)₂, C₁₄H₂₉(CH₃)₂SiN(CH₃)₂, C₁₅H₃₁(CH₃)₂SiN(CH₃)₂, C₁₆H₃₃(CH₃)₂SiN(CH₃)₂, C₁₇H₃₅(CH₃)₂SiN(CH₃)₂, C₁₈H₃₇(CH₃)₂SiN(CH₃)₂, and C₃₀H₆₁(CH₃)₂SiN(CH₃)₂;alkylmethyl(dimethylamino)silanes such as C₅H₁₁(CH₃)HSiN(CH₃)₂, C₆H₁₃(CH₃)HSiN(CH₃)₂, C₇H₁₅(CH₃)HSiN(CH₃)₂, C₈H₁₇(CH₃)HSiN(CH₃)₂, C₉H₁₉(CH₃)HSiN(CH₃)₂, C₁₀H₂₁(CH₃)HSiN(CH₃)₂, C₁₁H₂₃(CH₃)HSiN(CH₃)₂, C₁₂H₂₅(CH₃)HSiN(CH₃)₂, C₁₃H₂₇(CH₃)HSiN(CH₃)₂, C₁₄H₂₉(CH₃)HSiN(CH₃)₂, C₁₅H₃₁(CH₃)HSiN(CH₃)₂, C₁₆H₃₃(CH₃)HSiN(CH₃)₂, C₁₇H₃₅(CH₃)HSiN(CH₃)₂, C₁₈H₃₇(CH₃)HSiN(CH₃)₂, and C₃₀H₆₁(CH₃)HSiN(CH₃)₂; and fluoroalkylethyl(dimethylamino)silanes such as C₂F₅C₂H₄(CH₃)₂SiN(CH₃)₂, C₃F₇C₂H₄(CH₃)₂SiN(CH₃)₂, C₄F₉C₂H₄(CH₃)₂SiN(CH₃)₂, C₅F₁₁C₂H₄(CH₃)₂SiN(CH₃)₂, C₆F₁₃C₂H₄(CH₃)₂SiN(CH₃)₂, C₇F₁₅C₂H₄(CH₃)₂SiN(CH₃)₂, and C₈F₁₇C₂H₄(CH₃)₂SiN(CH₃)₂;N-(alkyldimethylsilyl)-N-methylacetamides such as (CH₃)₃SiN(CH₃)COCH₃ and C₄H₉(CH₃)₂SiN(CH₃)COCH₃; N-(alkyldimethylsilyl)-N-methylfluoroacetamides such as (CH₃)₃SiN(CH₃)COCF₃ (N-methyl-N-trimethylsilyltrifluoroacetamide: MSTFA) and C₄H₉(CH₃)₂SiN(CH₃)COCF₃ (N-methyl-N-(tert-butyldimethylsilyl)-trifluoroacetamide: MTBSTFA); and compounds in which a methyl group in alkyldimethyl(dimethylamino)silane, alkylmethyl(dimethylamino)silane, fluoroalkylethyl(dimethylamino)silane, N-(alkyldimethylsilyl)-N-methylfluoroacetamide, and N-(alkyldimethylsilyl)-N-methylfluoroacetamide is replaced with an alkyl group having 1 to 18 carbon atoms, such as an ethyl group, a propyl group, or a butyl group.

Above all, the compound represented by Formula (1) is preferably C₃H₇(CH₃)₂SiN(CH₃)₂, C₄H₉(CH₃)₂SiN(CH₃)₂, C₅H₁₁(CH₃)₂SiN(CH₃)₂, C₆H₁₃(CH₃)₂SiN(CH₃)₂, C₇H₁₅(CH₃)₂SiN(CH₃)₂, C₈H₁₇(CH₃)₂SiN(CH₃)₂, MSTFA, or MTBSTFA, and more preferably C₄H₉(CH₃)₂SiN(CH₃)₂.

The silazane compound is a compound having a Si-N-Si bond. The number of Si-N-Si bonds is not particularly limited, and is preferably 1 to 3 and more preferably 1.

The silazane compound is preferably a disilazane compound and more preferably a compound represented by Formula (2).

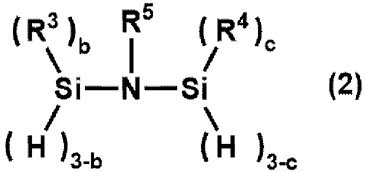

R³ and R⁴ each independently represent a hydrocarbon group which may have a halogen atom.

The definition and suitable aspects of the hydrocarbon group represented by R³ and R⁴ are the same as those of the hydrocarbon group represented by R¹ in Formula (1).

In a case where a plurality of R³'s are present, the groups represented by the plurality of R³'s may be the same as or different from each other. In addition, in a case where a plurality of R⁴'s are present, the groups represented by the plurality of R⁴'s may be the same as or different from each other.

R⁵ represents a hydrogen atom or a hydrocarbon group which may have a halogen atom.

The definition and suitable aspects of the hydrocarbon group represented by R⁵ are the same as those of the hydrocarbon group represented by R² in Formula (1).

R⁵ is preferably a hydrogen atom.

b and c each independently represent an integer of 1 to 3, and are each preferably 2 or 3 and more preferably 2.

Examples of the silazane compound include tetramethyl disilazane (TMDS), hexamethyl disilazane (HMDS), tetraethyl disilazane, hexaethyl disilazane, tetrapropyl disilazane, hexapropyl disilazane, tetrabutyl disilazane, and hexabutyl disilazane, among which TMDS or HMDS is preferable and TMDS is more preferable.

Examples of the silazane compound other than those mentioned above also include [C₄H₉(CH₃)₂Si]₂NH, [C₅H₁₁(CH₃)₂Si]₂NH, [C₆H₁₃(CH₃)₂Si]₂NH, [C₇H₁₅(CH₃)₂Si]₂NH, [C₈H₁₇(CH₃)₂Si]₂NH, [C₉H₁₉(CH₃)₂Si]₂NH, [C₁₀H₂₁(CH₃)₂Si]₂NH, [C₁₁H₂₃(CH₃)₂Si]₂NH, [C₁₂H₂₅(CH₃)₂Si]₂NH, [C₁₃H₂₇(CH₃)₂Si]₂NH, [C₁₄H₂₉(CH₃)₂Si]₂NH, [C₁₅H₃₁(CH₃)₂Si]₂NH, [C₁₆H₃₃(CH₃)₂Si]₂NH, [C₁₇H₃₅(CH₃)₂Si]₂NH, [C₁₈H₃₇(CH₃)₂Si]₂NH, [C₂F₅C₂H₄(CH₃)₂Si]₂NH, [C₃F₇C₂H₄(CH₃)₂Si]₂NH, [C₄F₉C₂H₄(CH₃)₂Si]₂NH, [C₅F₁₁C₂H₄(CH₃)₂Si]₂NH, [C₆F₁₃C₂H₄(CH₃)₂Si]₂NH, [C₇F₁₅C₂H₄(CH₃)₂Si]₂NH, [C₈F₁₇C₂H₄(CH₃)₂Si]₂NH, [(C₂H₅)₃Si]₂NH, [C₃H₇(C₂H₅)₂Si]₂NH, [C₄H₉(C₂H₅)₂Si]₂NH, [C₅H₁₁(C₂H₅)₂Si]₂NH, [C₆H₁₃(C₂H₅)₂Si]₂NH, [C₇H₁₅(C₂H₅)₂Si]₂NH, [C₈H₁₇(C₂H₅)₂Si]₂NH, [C₉H₁₉(C₂H₅)₂Si]₂NH, [C₁₀H₂₁(C₂H₅)₂Si]₂NH, [C₁₁H₂₃(C₂H₅)₂Si]₂NH, [C₁₂H₂₅(C₂H₅)₂Si]₂NH, [C₁₃H₂₇(C₂H₅)₂Si]₂NH, [C₁₄H₂₉(C₂H₅)₂Si]₂NH, [C₁₅H₃₁(C₂H₅)₂Si]₂NH, [C₁₆H₃₃(C₂H₅)₂Si]₂NH, [C₁₇H₃₅(C₂H₅)₂Si]₂NH, and [C₁₈H₃₇(C₂H₅)₂Si]₂NH.

Examples of the compound having a Si-N bond other than those mentioned above also include N,O-bis(trimethylsilyl)trifluoroacetamide (BSTFA) and N-trimethylsilylimidazole (TMSI).

### <Compound represented by Formula (3)>

The silylation agent is also preferably a compound represented by Formula (3).

(R⁶)_{d}Si(H)ₑ(X¹)_{4-d-e} (3)

In Formula (3), R⁶'s each independently represent a hydrocarbon group which may have a halogen atom.

The definition and suitable aspects of the hydrocarbon group represented by R⁶ are the same as those of the hydrocarbon group represented by R¹ in Formula (1).

The group represented by R⁶ is preferably an alkyl group having 1 to 25 carbon atoms which may have a halogen atom, and more preferably a linear alkyl group having 1 to 20 carbon atoms.

In a case where a plurality of R⁶'s are present, the groups represented by the plurality of R⁶'s may be the same as or different from each other.

In a case where a plurality of R⁶'s are present, the total number of carbon atoms in all the groups represented by R⁶'s is preferably 3 to 35 and more preferably 3 to 25.

X¹ represents a hydrolyzable group. Examples of the hydrolyzable group include an -O-R⁷ group and a halogen atom. R⁷ represents a hydrocarbon group which may have a halogen atom.

The definition and suitable aspects of the hydrocarbon group represented by R⁷ are the same as those of the hydrocarbon group represented by R² in Formula (1).

Examples of the halogen atom include a chlorine atom, a bromine atom, and an iodine atom, among which a chlorine atom is preferable.

X¹ is preferably an -O-R⁷ group, more preferably an alkoxy group, and still more preferably an alkoxy group having 1 to 3 carbon atoms.

In a case where a plurality of X¹'s are present, the groups represented by the plurality of X¹'s may be the same as or different from each other, and are preferably the same.

d represents an integer of 1 to 3 and is preferably 1 or 2 and more preferably 1.

e represents an integer of 0 to 2 and is preferably 0.

d + e represents an integer of 1 to 3 and is preferably 1 or 2 and more preferably 1.

Examples of the silylation agent represented by Formula (3) include an alkoxysilane compound (a compound represented by Formula (3) in which X¹ is an alkoxy group) and a chlorosilane compound (a compound represented by Formula (3) in which X¹ is a chlorine atom).

Examples of the alkoxysilane compound include alkylmethoxysilanes such as CH₃Si(OCH₃)₃, C₂H₅Si(OCH₃)₃, C₃H₇Si(OCH₃)₃, C₄H₉Si(OCH₃)₃, C₅H₁₁Si(OCH₃)₃, C₆H₁₃Si(OCH₃)₃, C₇H₁₅Si(OCH₃)₃, C₈H₁₇Si(OCH₃)₃, C₉H₁₉Si(OCH₃)₃, C₁₀H₂₁Si(OCH₃)₃, C₁₁H₂₃Si(OCH₃)₃, C₁₂H₂₅Si(OCH₃)₃, C₁₃H₂₇Si(OCH₃)₃, C₁₄H₂₉Si(OCH₃)₃, C₁₅H₃₁Si(OCH₃)₃, C₁₆H₃₃Si(OCH₃)₃, C₁₇H₃₅Si(OCH₃)₃, C₁₈H₃₇Si(OCH₃)₃, C₂₀H₄₁Si(OCH₃)₃, C₂₄H₄₉Si(OCH₃)₃, (CH₃)₂Si(OCH₃)₂, C₂H₅Si(CH₃)(OCH₃)₂, (C₂H₅)₂Si(OCH₃)₂, C₃H₇Si(CH₃)(OCH₃)₂, (C₃H₇)₂Si(OCH₃)₂, C₄H₉Si(CH₃)(OCH₃)₂, (C₄H₉)₂Si(OCH₃)₂, C₅H₁₁Si(CH₃)(OCH₃)₂, C₆H₁₃Si(CH₃)(OCH₃)₂, C₇H₁₅Si(CH₃)(OCH₃)₂, C₈H₁₇Si(CH₃)(OCH₃)₂, C₉H₁₉Si(CH₃)(OCH₃)₂, C₁₀H₂₁Si(CH₃)(OCH₃)₂, C₁₁H₂₃Si(CH₃)(OCH₃)₂, C₁₂H₂₅Si(CH₃)(OCH₃)₂, C₁₃H₂₇Si(CH₃)(OCH₃)₂, C₁₄H₂₉Si(CH₃)(OCH₃)₂, C₁₅H₃₁Si(CH₃)(OCH₃)₂, C₁₆H₃₃Si(CH₃)(OCH₃)₂, C₁₇H₃₅Si(CH₃)(OCH₃)₂, C₁₈H₃₇Si(CH₃)(OCH₃)₂, (CH₃)₃SiOCH₃, C₂H₅Si(CH₃)₂OCH₃, (C₂H₅)₂Si(CH₃)OCH₃, (C₂H₅)₃SiOCH₃, C₃H₇Si(CH₃)₂OCH₃, (C₃H₇)₂Si(CH₃)OCH₃, (C₃H₇)₃SiOCH₃, C₄H₉Si(CH₃)₂OCH₃, (C₄H₉)₃SiOCH₃, C₅H₁₁Si(CH₃)₂OCH₃, C₆H₁₃Si(CH₃)₂OCH₃, C₇H₁₅Si(CH₃)₂OCH₃, C₈H₁₇Si(CH₃ )₂OCH₃, C₉H₁₉Si(CH₃)₂OCH₃, C₁₀H₂₁Si(CH₃)₂OCH₃, C₁₁H₂₃Si(CH₃)₂OCH₃, C₁₂H₂₅Si(CH₃)₂OCH₃, C₁₃H₂₇Si(CH₃)₂OCH₃, C₁₄H₂₉Si(CH₃)₂OCH₃, C₁₅H₃₁Si(CH₃)₂OCH₃, C₁₆H₃₃Si(CH₃)₂OCH₃, C₁₇H₃₅Si(CH₃)₂OCH₃, C₁₈H₃₇Si(CH₃)₂OCH₃, (CH₃)₂Si(H)OCH₃, CH₃Si(H)₂OCH₃, (C₂H₅)₂Si(H)OCH₃, C₂H₅Si(H)₂OCH₃, C₂H₅Si(CH₃)(H)OCH₃, and (C₃H₇)₂Si(H)OCH₃;fluoromethoxysilanes such as CF₃CH₂CH₂Si(OCH₃)₃, C₂F₅CH₂CH₂Si(OCH₃)₃, C₃F₇CH₂CH₂Si(OCH₃)₃, C₄F₉CH₂CH₂Si(OCH₃)₃, C₅F₁₁CH₂CH₂Si(OCH₃)₃, C₆F₁₃CH₂CH₂Si(OCH₃)₃, C₇F₁₅CH₂CH₂Si(OCH₃)₃, C₈F₁₇CH₂CH₂Si(OCH₃)₃, CF₃CH₂CH₂Si(CH₃)(OCH₃)₂, C₂F₅CH₂CH₂Si(CH₃)(OCH₃)₂, C₃F₇CH₂CH₂Si(CH₃)(OCH₃)₂, C₄F₉CH₂CH₂Si(CH₃)(OCH₃)₂, C₅F₁₁CH₂CH₂Si(CH₃)(OCH₃)₂, C₆F₁₃CH₂CH₂Si(CH₃)(OCH₃)₂, C₇F₁₅CH₂CH₂Si(CH₃)(OCH₃)₂, C₅F₁₇CH₂CH₂Si(CH₃)(OCH₃)₂, CF₃CH₂CH₂Si(CH₃)₂OCH₃, C₂F₅CH₂CH₂Si(CH₃)₂OCH₃, C₃F₇CH₂CH₂Si(CH₃)₂OCH₃, C₄F₉CH₂CH₂Si(CH₃)₂OCH₃, C₅F₁₁CH₂CH₂Si(CH₃)₂OCH₃, C₆F₁₃CH₂CH₂Si(CH₃)₂OCH₃, C₇F₁₅CH₂CH₂Si(CH₃)₂OCH₃, C₈F₁₇CH₂CH₂Si(CH₃)₂OCH₃, and CF₃CH₂CH₂Si(CH₃)(H)OCH₃; and alkoxysilane compounds in which a methoxy group in alkylmethoxysilanes and fluoromethoxysilanes is replaced with an alkoxy group having 2 to 10 carbon atoms.

Examples of the chlorosilane compound include trimethylchlorosilane (TMCS), triethylchlorosilane, tributylchlorosilane, triphenylchlorosilane, dimethyldichlorosilane (DMCS), t-butyldimethylchlorosilane, dimethylphenylchlorosilane, and di-tert-butyl dichlorosilane.

The silane compound represented by Formula (3) is preferably an alkoxysilane compound, more preferably an alkylmethoxysilane, and still more preferably an alkyltrimethoxysilane.

The silylation agent is preferably a compound having a Si-N bond or an alkoxysilane compound, more preferably a compound having a Si-N bond, still more preferably a compound represented by Formula (1) or a silazane compound, and particularly preferably a silazane compound.

The silylation agents may be used alone or in combination of two or more thereof.

The content of the silylation agent is preferably 0.01% to 10% by mass, more preferably 0.1% to 5% by mass, and still more preferably 0.3% to 3% by mass with respect to the total mass of the chemical liquid.

### [Specific silicon compound]

The chemical liquid according to the second aspect of the present invention contains a specific silicon compound which is a compound selected from the group consisting of a silazane compound, a compound represented by Formula (1), and an alkoxysilane compound.

The details and suitable aspects of the silazane compound, the compound represented by Formula (1), and the alkoxysilane compound, each of which is the specific silicon compound, are the same as those of the silazane compound, the compound represented by Formula (1), and the alkoxysilane compound described above.

The specific silicon compounds may be used alone or in combination of two or more thereof.

The content of the specific silicon compound is preferably 0.01% to 10% by mass, more preferably 0.1% to 5% by mass, and still more preferably 0.3% to 3% by mass with respect to the total mass of the chemical liquid.

### [Aprotic solvent]

The chemical liquid according to the first aspect of the present invention and the chemical liquid according to the second aspect of the present invention contain an aprotic solvent. The aprotic solvent is a solvent that does not have proton donating properties.

Examples of the aprotic solvent include a carbonate solvent, an ester solvent, an ether solvent, a ketone solvent, a hydrocarbon solvent, a halogen-containing solvent, a sulfoxide solvent, and a nitrogen-containing solvent that does not have an N-H bond.

Examples of the carbonate solvent include propylene carbonate, dimethyl carbonate, diethyl carbonate, and ethyl methyl carbonate.

Examples of the ester solvent include chain-like ester solvents such as ethyl acetate, propyl acetate, butyl acetate, methoxybutyl acetate, ethylene glycol monomethyl ether acetate, ethylene glycol monoethyl ether acetate, ethylene glycol monobutyl ether acetate, ethylene glycol diacetate, diethylene glycol monomethyl ether acetate, diethylene glycol monoethyl ether acetate, diethylene glycol monobutyl ether acetate, diethylene glycol diacetate, triethylene glycol monomethyl ether acetate, triethylene glycol monoethyl ether acetate, triethylene glycol monobutyl ether acetate, triethylene glycol diacetate, tetraethylene glycol monomethyl ether acetate, tetraethylene glycol monoethyl ether acetate, tetraethylene glycol monobutyl ether acetate, tetraethylene glycol diacetate, propylene glycol monomethyl ether acetate, propylene glycol monoethyl ether acetate, propylene glycol monobutyl ether acetate, propylene glycol diacetate, dipropylene glycol monomethyl ether acetate, dipropylene glycol monoethyl ether acetate, dipropylene glycol monobutyl ether acetate, dipropylene glycol diacetate, tripropylene glycol monomethyl ether acetate, tripropylene glycol monoethyl ether acetate, tripropylene glycol monobutyl ether acetate, tripropylene glycol diacetate, tetrapropylene glycol monomethyl ether acetate, tetrapropylene glycol diacetate, and butylene glycol monomethyl ether acetate, and lactone solvents such as γ-butyrolactone, γ-valerolactone, γ-hexanolactone, γ-heptanolactone, γ-octanolactone, γ-nonanolactone, γ-decanolactone, γ-undecanolactone, γ-dodecanolactone, δ-valerolactone, δ-hexanolactone, δ-octanolactone, δ-nonanolactone, δ-decanolactone, δ-undecanolactone, δ-dodecanolactone, and ε-hexanolactone.

Examples of the ether solvent include glycol dialkyl ether solvents such as ethylene glycol dimethyl ether, ethylene glycol diethyl ether, ethylene glycol dibutyl ether, diethylene glycol dimethyl ether, diethylene glycol ethyl methyl ether, diethylene glycol diethyl ether, diethylene glycol butyl methyl ether, diethylene glycol dibutyl ether, triethylene glycol dimethyl ether, triethylene glycol diethyl ether, triethylene glycol dibutyl ether, triethylene glycol butyl methyl ether, tetraethylene glycol dimethyl ether, tetraethylene glycol diethyl ether, tetraethylene glycol dibutyl ether, propylene glycol dimethyl ether, propylene glycol diethyl ether, propylene glycol dibutyl ether, dipropylene glycol dimethyl ether, dipropylene glycol methyl propyl ether, dipropylene glycol diethyl ether, dipropylene glycol dibutyl ether, tripropylene glycol dimethyl ether, tripropylene glycol diethyl ether, tripropylene glycol dibutyl ether, tetrapropylene glycol dimethyl ether, and butylene glycol dimethyl ether; dialkyl ether solvents such as diethyl ether, dipropyl ether, ethyl butyl ether, dibutyl ether, ethyl amyl ether, diamyl ether, methylcyclopentyl ether, ethylhexyl ether, dihexyl ether, and dioctyl ether; and cyclic ether solvents such as tetrahydrofuran and dioxane.

Examples of the ketone solvent include acetone, acetylacetone, methyl ethyl ketone, methyl propyl ketone, methyl butyl ketone, cyclohexanone, and isophorone.

Examples of the hydrocarbon solvent include aromatic hydrocarbon solvents such as benzene, toluene, xylene, ethylbenzene, and tetralin, and aliphatic hydrocarbon solvents such as hexane, heptane, octane, and cyclohexane.

Examples of the halogen-containing solvent include perfluorocarbons such as perfluorooctane, perfluorononane, perfluorocyclopentane, perfluorocyclohexane, and hexafluorobenzene; hydrofluorocarbons such as 1,1,1,3,3-pentafluorobutane, octafluorocyclopentane, 2,3-dihydrodecafluoropentane, and ZEORORA H (manufactured by Zeon Corporation); hydrofluoroethers such as methylperfluoroisobutyl ether, methylperfluorobutyl ether, ethylperfluorobutyl ether, ethylperfluoroisobutyl ether, ASAHIKLIN AE-3000 (manufactured by AGC Inc.), and Novec 7100, Novec 7200, Novec 7300, and Novec 7600 (all manufactured by 3M Company); chlorocarbons such as tetrachloromethane; hydrochlorocarbons such as chloroform; chlorofluorocarbons such as dichlorodifluoromethane; hydrochlorofluorocarbons such as 1,1-dichloro-2,2,3,3,3-pentafluoropropane, 1,3-dichloro-1,1,2,2,3-pentafluoropropane, 1-chloro-3,3,3-trifluoropropene, and 1,2-dichloro-3,3,3-trifluoropropene; perfluoroethers; and perfluoropolyethers.

Examples of the sulfoxide solvent include dimethyl sulfoxide.

Examples of the nitrogen-containing solvent that does not have an N-H bond include N,N-dimethylformamide, N,N-dimethylacetamide, N-methyl-2-pyrrolidone, triethylamine, and pyridine.

The aprotic solvent is preferably a carbonate solvent, an ester solvent, or an ether solvent, more preferably a carbonate solvent, a cyclic ester solvent, or a glycol ether solvent, and still more preferably a carbonate solvent.

Above all, propylene carbonate, γ-butyrolactone,γ-valerolactone, PGMEA, ethylene glycol dibutyl ether, diethylene glycol diethyl ether, diethylene glycol dibutyl ether, propylene glycol dimethyl ether, or propylene glycol dibutyl ether is preferable, propylene carbonate, γ-butyrolactone,γ-valerolactone, propylene glycol dimethyl ether, or diethylene glycol dibutyl ether is more preferable, and propylene carbonate is still more preferable.

The aprotic solvents may be used alone or in combination of two or more thereof. **In** a case where two or more aprotic solvents are used in combination, it is preferable that the aprotic solvents are miscible with each other.

The content of the aprotic solvent is preferably 90% by mass or more, more preferably 95% by mass or more, and still more preferably 97% by mass or more with respect to the total mass of the chemical liquid. The upper limit of the content of the aprotic solvent is less than 100% by mass, preferably 99.9% by mass or less, and more preferably 99.7% by mass or less.

### [Alcohol]

The chemical liquid of the first aspect and the chemical liquid of the second aspect contain an alcohol.

The alcohol is an organic compound having at least one alcoholic hydroxyl group.

The number of hydroxyl groups contained in the alcohol may be 1 or more and is preferably 2 or more. The upper limit of the number of hydroxyl groups is not particularly limited and is preferably 6 or less and more preferably 4 or less.

The alcohol may be linear or branched, and is preferably linear. The alcohol may have a ring structure in the molecule thereof.

The number of carbon atoms contained in the alcohol is not particularly limited and is preferably 1 to 25, more preferably 1 to 15, still more preferably 2 to 10, and particularly preferably 2 to 6 from the viewpoint that the effect of the present invention is more excellent.

The molecular weight of the alcohol is not particularly limited and is preferably 300 or less, more preferably 200 or less, and still more preferably 150 or less from the viewpoint that the effect of the present invention is more excellent. The lower limit of the molecular weight of the alcohol is not particularly limited and is preferably 30 or more and more preferably 40 or more.

The alcohol may have an etheric oxygen atom in the molecule thereof. The etheric oxygen atom is intended to mean an oxygen atom present between carbon-carbon bonds in a molecule. Examples of the alcohol having an etheric oxygen atom in the molecule thereof include dialkylene glycol, trialkylene glycol, polyalkylene glycol, alkylene glycol monoalkyl ether, dialkylene glycol monoalkyl ether, trialkylene glycol monoalkyl ether, and polyalkylene glycol monoalkyl ether.

Examples of the alcohol include monools such as 1-propanol, 1-butanol, 1-pentanol, 1-hexanol, 1-heptanol, 1-octanol, lauryl alcohol, 1-decanol, 1-nonanol, 1-octadecanol, methanol, ethanol, 2-ethylhexanol, isopropanol, 2-butanol, isobutyl alcohol, 3-methyl-1-butanol, tert-butyl alcohol, 2-pentanol, t-pentyl alcohol, 4-methyl-2-pentanol, 2-hexanol, cyclopentanol, 2-heptanol, 2-octanol, 2-ethylpentanol, 4-octanol, 3-methoxy-3-methyl-1-butanol, 3-methoxy-1-butanol, and 1-methoxy-2-butanol; glycols such as propylene glycol, ethylene glycol, diethylene glycol, dipropylene glycol, triethylene glycol, tetraethylene glycol, 2-methyl-1,3-propanediol, 1,3-propanediol, 2,2-dimethyl-1,3-propanediol, 1,4-butanediol, 1,3-butanediol, 1,2-butanediol, 2,3-butanediol, hexylene glycol, pinacol, and 1,3-cyclopentanediol; and polyols such as glycerin, among which glycols are preferable.

Above all, the alcohol is preferably propylene glycol, ethylene glycol, diethylene glycol, dipropylene glycol, 1-propanol, 1-butanol, 1-pentanol, 1-hexanol, 1-heptanol, 1-octanol, lauryl alcohol, 1-octadecanol, 2-ethylhexanol, or 2-octanol, more preferably propylene glycol, 1-propanol, 1-butanol, 1-pentanol, 1-hexanol, 1-heptanol, 1-octanol, or 2-ethylhexanol, still more preferably propylene glycol, ethylene glycol, diethylene glycol, or dipropylene glycol, and particularly preferably propylene glycol or dipropylene glycol.

The alcohols may be used alone or in combination of two or more thereof.

The content of the alcohol is 5 to 200 ppm by mass with respect to the total mass of the chemical liquid. From the viewpoint that the effect of the present invention is more excellent, the content of the alcohol is preferably 10 to 150 ppm by mass, more preferably 30 to 120 ppm by mass, and still more preferably 30 to 100 ppm by mass with respect to the total mass of the chemical liquid.

In a case where the content of the alcohol is more than 200 ppm by mass or less than 5 ppm by mass with respect to the total mass of the chemical liquid, the contact angle of water decreases, which is not preferable from the viewpoint that the effect of the present invention is deteriorated.

The content of the alcohol can be measured using gas chromatography mass spectrometry (GC-MS) or the like.

### [Water]

The chemical liquid of the first aspect and the chemical liquid of the second aspect may contain water.

The water is not particularly limited, and examples thereof include distilled water, ion exchange water, pure water, and ultrapure water, among which ultrapure water is preferable.

From the viewpoint that the effect of the present invention is more excellent, the content of water is preferably 300 ppm by mass or less, more preferably 200 ppm by mass or less, still more preferably 100 ppm by mass or less, particularly preferably 30 ppm by mass or less, and most preferably 10 ppm by mass or less with respect to the total mass of the chemical liquid. The lower limit of the content of water is not particularly limited and is preferably 1 ppm by mass or more and more preferably 5 ppm by mass or more.

The water may be any of water that is intentionally added, water that is inevitably contained in a raw material of a chemical liquid, or water that is inevitably contained during the manufacturing, storage, and/or transportation of a chemical liquid.

The method of adjusting the content of water is not particularly limited, and examples thereof include a method of adding water, a method of removing water from a chemical liquid and/or a raw material used for preparing the chemical liquid, and a combination thereof.

As the method of removing water, a known dehydration method can be used. Examples of the dehydration method include distillation, dehydration using a water adsorbent, and dehydration using a dehydrating film.

The content of water can be measured using a device which adopts the Karl Fischer moisture measurement method as the principle of measurement. As the above-mentioned device, for example, "CA-200" (manufactured by Nittoseiko Analytech Co., Ltd.) and "MKC-710M" (manufactured by Kyoto Electronics Manufacturing Co., Ltd.) can be used.

### [Other components]

The chemical liquid of the first aspect and the chemical liquid of the second aspect may contain other components in addition to the above-mentioned components. Examples of other components include an acidic compound and a basic compound.

The acidic compound is a compound that exhibits acidity (a pH of less than 7.0) in an aqueous solution, and examples thereof include inorganic acids such as hydrochloric acid, nitric acid, sulfuric acid, phosphoric acid, hydrobromic acid, and hydrofluoric acid, and organic acids such as paratoluenesulfonic acid, benzenesulfonic acid, methanesulfonic acid, and trifluoromethanesulfonic acid.

The basic compound is a compound that exhibits basicity (a pH of more than 7.0) in an aqueous solution, and examples thereof include inorganic bases such as lithium hydroxide, sodium hydroxide, potassium hydroxide, cesium hydroxide, calcium hydroxide, strontium hydroxide, and barium hydroxide, and organic bases such as pyridine and a quaternary ammonium salt.

The acidic compounds and the basic compounds may be used alone or in combination of two or more thereof.

### [Manufacturing method of chemical liquid]

### <Liquid preparation step>

The manufacturing method of the chemical liquid according to the embodiment of the present invention is not particularly limited. For example, the chemical liquid can be manufactured by mixing the above-mentioned components. The order or timing of mixing the components and the order and timing of mixing the components are not particularly limited. For example, a method of adding a silylation agent and an alcohol to a stirrer such as a mixer containing a purified aprotic solvent, followed by thorough stirring to manufacture the chemical liquid of the first aspect is exemplified.

The manufacturing process of the chemical liquid according to the embodiment of the present invention may have a step selected from the group consisting of a distillation step of distilling a raw material, a dehydration step of dehydrating a chemical liquid, a metal removing step of removing a metal component from a chemical liquid, a filtration step of filtering a chemical liquid, and an electricity removing step of removing electricity from a chemical liquid.

### <Container>

For example, a known container can be used as a container for accommodating the chemical liquid.

The container is preferably a container for semiconductor use, with a high degree of internal cleanliness and low elution of impurities.

Examples of the container include "CLEAN BOTTLE" series (manufactured by Aicello Chemical Co., Ltd.) and "PURE BOTTLE" (manufactured by Kodama Plastics Co., Ltd.). In addition, from the viewpoint of preventing the incorporation of impurities (contamination) into the raw materials and the chemical liquid, it is also preferable to use a multi-layer container in which an interior wall of the container has a six-layer structure consisting of six types of resins, or a multi-layer container in which an interior wall of the container has a seven-layer structure consisting of seven types of resins.

Examples of the multi-layer container include the containers described in JP2015-123351A, the contents of which are incorporated herein by reference.

Examples of materials for the interior wall of the container include a first resin of at least one selected from the group consisting of a polyethylene resin, a polypropylene resin, and a polyethylene-polypropylene resin, a second resin different from the first resin, and a metal such as stainless steel, Hastelloy, Inconel, or Monel. In addition, the interior wall of the container is preferably formed of or coated with the above-mentioned materials.

The second resin is preferably a fluororesin (perfluororesin). In a case where a fluororesin is used, it is preferable from the viewpoint that the elution of an oligomer of ethylene or propylene can be suppressed.

Examples of the container include a FluoroPure PFA composite drum (manufactured by Entegris, Inc.) and the containers described on page 4 of JP1991-502677A (JP-H03-502677A), page 3 of WO2004/016526A, and page 9 and page 16 of WO99/046309A.

In addition to the fluororesin, for example, quartz and an electropolished metal material are also preferable for the interior wall of the container.

Examples of the stainless steel include known stainless steel.

Above all, the stainless steel is preferably a stainless steel containing 8% by mass or more of Ni, and more preferably an austenitic stainless steel containing 8% by mass or more of Ni.

Examples of Ni-Cr alloys include known Ni-Cr alloys.

Above all, a Ni-Cr alloy having a Ni content of 40% to 75% by mass and a Cr content of 1% to 25% by mass is preferable.

The Ni-Cr alloy may further contain boron, silicon, tungsten, molybdenum, copper, or cobalt, in addition to the above-mentioned alloy, if necessary.

Examples of the method of electropolishing a metal material include known methods. Specific examples of the electropolishing method include the methods described in paragraphs [0011] to [0014] of JP2015-227501A, the contents of which are incorporated herein by reference and the methods described in paragraphs [0036] to [0042] of JP2008-264929A, the contents of which are incorporated herein by reference.

It is preferable that the metal material is subjected to buffing. Examples of the buffing method include known methods.

The size of abrasive grains used for finishing the buffing is preferably # 400 or less from the viewpoint that surface asperities of the metal material are likely to be further reduced. The buffing is preferably carried out prior to the electropolishing.

The metal material may be subjected to one of multi-stage buffing that is carried out by changing the size or the like of abrasive grains, acid washing, magnetorheological finishing, and the like, or a combination of two or more thereof.

It is preferable to clean the inside of the container before being filled with the chemical liquid.

The liquid used for cleaning can be appropriately selected depending on the intended use, and is preferably a liquid containing the chemical liquid or at least one of the components added to the chemical liquid.

From the viewpoint of preventing changes in the components of the chemical liquid during storage, the inside of the container may be purged with an inert gas (for example, nitrogen and argon) having a purity of 99.99995% by volume or higher. **In** particular, a gas having a low moisture content is preferable. **In** addition, transportation and storage of the container accommodating the chemical liquid may be carried out either at normal temperature or under temperature control. Above all, it is preferable to control the temperature in a range of -20°C to 20°C from the viewpoint of preventing deterioration.

### [Applications of chemical liquid]

The chemical liquid according to the embodiment of the present invention is a chemical liquid used in the manufacture of a semiconductor, and is preferably used for treating a substrate to be modified. By the above treatment, a modified substrate is obtained in which a coating film containing silicon atoms is formed on the surface of the substrate to be modified. The silicon atom contained in the coating film containing silicon atoms is a silicon atom derived from the above-mentioned silylation agent or specific silicon compound.

The method of treating the substrate is not particularly limited, and examples thereof include a method in which a chemical liquid is brought into contact with a substrate to be modified. The manufacturing method of a modified substrate will be described later.

### <Substrate to be modified>

The substrate to be modified is preferably a substrate having a region made of an insulator.

The region made of an insulator preferably has a functional group on the surface thereof.

The functional group is a functional group that reacts with the above-mentioned silylation agent or specific silicon compound to introduce a silyl group upon contact therebetween, and examples thereof include a hydroxyl group, an amino group, a carboxy group, and an amide group, among which a hydroxyl group is preferable.

The insulator is preferably a metal oxide.

Examples of metals contained in the metal oxide include silicon (Si), aluminum (Al), tantalum (Ta), zirconium (Zr), and lanthanum (La). In the present specification, Si is a metal.

Above all, a silicon oxide is preferable as the metal oxide. Specific examples of the silicon oxide include a material represented by a composition of SiO_{y} (in which y preferably represents 0.5 to 2.0 and more preferably 1.0 to 2.0) and a material represented by a composition of SiO_{z}C_{w} (in which z preferably represents 0.5 to 2.0 and more preferably 1.0 to 2.0, and w preferably represents 0.5 to 2.0 and more preferably 1.0 to 2.0). The material represented by a composition of SiO_{y} and the material represented by a composition of SiO_{z}C_{w} may further contain hydrogen. Examples of the material represented by a composition of SiO_{z}C_{w} include Si(OC₂H₅)₄ (tetraethyl orthosilicate, TEOS).

Above all, a material represented by a composition of SiO₂ (silicon dioxide) or TEOS is preferable as the silicon oxide.

The method of forming the region made of an insulator is not particularly limited, and any known method can be used. Examples of the method of forming the region made of an insulator include a CVD method, a physical vapor deposition method, plasma irradiation, heat treatment of a silicon substrate, and application of a precursor compound.

The substrate to be modified may have another region different from the region made of an insulator.

Examples of the other region include a conductive metal region.

The type of the metal contained in the metal region is not particularly limited and may be, for example, at least one metal selected from the group consisting of aluminum (Al), copper (Cu), ruthenium (Ru), cobalt (Co), tungsten (W), titanium (Ti), tantalum (Ta), chromium (Cr), hafnium (Hf), osmium (Os), platinum (Pt), nickel (Ni), manganese (Mn), iron (Fe), zirconium (Zr), molybdenum (Mo), palladium (Pd), lanthanum (La), and iridium (Ir).

The metal region may be any of simple substances or alloys of the above-mentioned metals. In addition, the metal region may contain an element other than the above-mentioned metals. Examples of the element other than the metals include hydrogen, phosphorus, and nitrogen.

It is also preferable that the surface of the other region does not have the above-mentioned functional group.

The method of forming the region made of a metal material is not particularly limited, and any known method can be used. Examples of the method of forming the region made of a metal material include a CVD method, plating, and a physical vapor deposition method.

The substrate to be modified preferably has at least two or more regions made of different materials on the surface thereof.

The substrate to be modified, which has at least two or more regions made of different materials on the surface thereof, is not particularly limited, and examples thereof include a substrate having a region made of an insulator and a metal region made of a conductive metal material, and a substrate having two or more regions made of different insulators, among which a substrate having a region made of an insulator and a metal region made of a conductive metal material is preferable.

It is preferable that the coating film containing silicon atoms, which is formed by the above-mentioned treatment, functions as a mask in a case where a material is deposited on the modified substrate by an ALD treatment. That is, in a case where the ALD treatment is carried out on the modified substrate, it is preferable that the material is not deposited in a region where the coating film containing silicon atoms formed by the chemical liquid according to the embodiment of the present invention is formed, and the material is deposited in a region where the coating film containing silicon atoms is not formed.

From the viewpoint that the effect of the present invention is more excellent, the contact angle of water with the coating film containing silicon atoms is preferably 70° or more, more preferably 80° or more, and still more preferably 90° or more. The upper limit of the contact angle of water with the coating film is not particularly limited and is often 120° or less.

The contact angle of the water is measured according to the following procedure.

Using a contact angle meter (DMS-501, manufactured by Kyowa Interface Science Co., Ltd.), the value of the contact angle 500 milliseconds after the liquid droplet of water comes into contact with the surface of a measurement object is measured three times, and the average value of the measured values is defined as the contact angle.

### [Manufacturing method of modified substrate]

### [Step 1: Manufacture of modified substrate]

The manufacturing method of a modified substrate according to the embodiment of the present invention has a step 1 of bringing a substrate having the region made of an insulator into contact with the chemical liquid according to the embodiment of the present invention to form a coating film containing silicon atoms on the region made of an insulator.

The contact method is not particularly limited, and any known method can be used. Examples of the contact method include a method of applying or spraying a chemical liquid onto a substrate to be modified and a method of immersing a substrate to be modified in a chemical liquid. In a case where the substrate is immersed in the chemical liquid, the chemical liquid may be allowed to convectively flow.

The temperature of the chemical liquid during the contact is not particularly limited and is preferably 10°C to 50°C.

The contact time between the chemical liquid and the substrate to be modified is not particularly limited, and is preferably 10 seconds to 10 hours, more preferably 30 seconds to 1 hour, and still more preferably 1 minute to 30 minutes.

After the chemical liquid is brought into contact with the substrate to be modified, the substrate may be heated. Heating can remove the solvent contained in the chemical liquid and make the coating film containing silicon atoms denser.

The heating temperature is not particularly limited and is preferably 50°C to 300°C and more preferably 60°C to 180°C.

The heating method is not particularly limited and examples thereof include a method of being brought into contact with a heating element (for example, heating with a hot plate) and a method of irradiation with infrared rays.

The substrate to be modified may be subjected to a pretreatment prior to the step 1. Examples of the pretreatment include a surface activation treatment and a cleaning treatment.

Examples of the surface activation treatment include a treatment of being brought into contact with a treatment liquid, a plasma treatment, a corona treatment, and an ozone treatment.

As the method of being brought into contact with a treatment liquid, the same method as the method of bringing the substrate to be modified into contact with the chemical liquid can be used, and a method of immersing the substrate to be modified in the treatment liquid is preferable. The treatment liquid may be allowed to convectively flow during the immersion.

The treatment liquid may be, for example, an aqueous solution containing an acidic compound. Examples of the acidic compound include hydrogen fluoride, hexafluorosilicic acid, hexafluorotitanic acid, hexafluorozirconic acid, hexafluorophosphoric acid, tetrafluoroboric acid, and salts thereof, among which hydrogen fluoride is preferable. The content of the acidic compound is preferably 0.01% to 5% by mass, more preferably 0.1% to 2% by mass, and still more preferably 0.1% to 5% by mass with respect to the total mass of the treatment liquid.

The temperature of the treatment liquid during the contact is not particularly limited and is preferably 10°C to 60°C.

The contact time between the treatment liquid and the substrate to be modified is not particularly limited, and is preferably 10 seconds to 10 hours, more preferably 10 seconds to 1 hour, and still more preferably 30 seconds to 30 minutes.

The methods of the plasma treatment and the ozone treatment are not particularly limited and known methods can be used.

The cleaning treatment may be, for example, a method of bringing a cleaning liquid such as water and an organic solvent into contact with the substrate to be modified. As the method of bringing the cleaning liquid into contact with the substrate to be modified, the same method as the method of bringing the treatment liquid into contact with the substrate to be modified can be used.

It is considered that, by carrying out the above-mentioned pretreatment, the functional group which has been inactivated is activated, and/or the impurities on the surface of the substrate to be modified are removed, so the reaction between the silylation agent or specific silicon compound and the surface of the substrate to be modified is promoted and therefore the coverage with the coating film containing silicon atoms is improved.

### [Step 2: Rinsing treatment]

It is also preferable that the manufacturing method of a modified substrate according to the embodiment of the present invention has, after the step 1, a step 2 of subjecting the substrate on which the coating film containing silicon atoms has been formed to a rinsing treatment. The rinsing treatment makes it possible to remove the chemical liquid components and/or impurities adhering to regions other than the predetermined region.

The rinsing method is not particularly limited and may be, for example, a method in which a rinsing liquid is brought into contact with the substrate on which the coating film containing silicon atoms is formed. The contact method may be the same method as the method of bringing the chemical liquid into contact with the substrate to be modified. The temperature during the contact is not particularly limited and is preferably 10°C to 50°C.

The rinsing liquid is not particularly limited and any known organic solvent can be used. Examples of the organic solvent include the above-mentioned alcohols and aprotic solvents.

### [Manufacturing method of laminate]

### [Step 3: ALD treatment]

The manufacturing method of a laminate according to the embodiment of the present invention has a step 3 of subjecting the modified substrate to an ALD treatment to form a metal film, a metal oxide film, or a metal nitride film on a region other than a region where a coating film containing silicon atoms is formed.

By the above-mentioned step 3, a laminate is obtained in which a coating film containing silicon atoms is provided on a region made of an insulator of a substrate which has a region made of an insulator, and a film formed by depositing a material by an ALD treatment is provided on a region other than the region made of an insulator.

The modified substrate may be a substrate on which a coating film containing silicon atoms is formed on a region made of an insulator by the above-mentioned step 1, or may be a substrate that has undergone other steps such as the step 2 after the step 1.

The method of the ALD treatment is not particularly limited and any known method can be used.

For example, a method is given in which a gas of a precursor serving as a raw material for a film (ALD film) formed by depositing a material by the ALD treatment is supplied to the surface of a modified substrate, and then the raw material is decomposed and/or chemically reacted with an oxidant or the like to deposit the material, thereby forming the ALD film.

The precursor is not particularly limited, and a known precursor can be used depending on the type of the ALD film to be formed. The precursor may be, for example, an organometallic compound. The compounds described in paragraphs [0021] to [0025] of JP2022-080800A and the like can be used as the precursor.

The oxidant is not particularly limited, and any known oxidant used for the ALD treatment can be used, examples of which include water, oxygen, and ozone.

The material constituting the ALD film can be controlled by the type of precursor to be supplied, the supply atmosphere, the oxidant, and the like.

The material for the ALD film to be formed is not particularly limited, and examples thereof include a metal, a metal oxide, and a metal nitride. Examples of the metal include aluminum, titanium, chromium, iron, cobalt, nickel, copper, zinc, yttrium, zirconium, niobium, molybdenum, ruthenium, palladium, lanthanum, cerium, hafnium, tantalum, tungsten, platinum, and bismuth. Examples of the metal oxide include aluminum oxide, titanium oxide, zinc oxide, zirconium oxide, hafnium oxide, and tantalum oxide. Examples of the metal nitride include titanium nitride and tantalum nitride.

In the ALD treatment, a treatment for modifying the surface of the region in which the coating film containing silicon atoms is not formed may be carried out.

After the ALD treatment, the thickness of the material deposited on the coating film containing silicon atoms is preferably as thin as possible, and is preferably 4.0 nm or less, more preferably 2.0 nm or less, and still more preferably 1.0 nm or less. The lower limit of the thickness of the material deposited is not particularly limited and is 0 nm.

In a case where a material is deposited by the ALD treatment on a region where a coating film containing silicon atoms is not formed, a ratio of a thickness of the material deposited on the region where a coating film containing silicon atoms is formed to a thickness of the material deposited on the region where a coating film containing silicon atoms is not formed is preferably 0.75 or less, more preferably 0.5 or less, and still more preferably 0.25 or less. The lower limit of the ratio is, for example, 0 and may be 0.

### [Step 4: Removal of coating film]

The manufacturing method of a laminate according to the embodiment of the present invention may have a step 4 of removing the coating film containing silicon atoms from the laminate obtained in the step 3. By the step 4, a laminate is obtained in which no layer is present on the region made of an insulator, and an ALD film is formed only on a region other than the region made of an insulator.

The method of removing the coating film containing silicon atoms is not particularly limited and examples thereof include dry etching, wet etching, and a combination thereof.

The dry etching may be, for example, a method of supplying reactive ions or reactive radicals to the surface of the laminate having a coating film containing silicon atoms. The reactive ions or reactive radicals may be generated by plasma or the like, and are preferably generated using a mixed gas containing one or more gases selected from the group consisting of oxygen, nitrogen, and hydrogen. The mixed gas may contain a rare gas. In addition, the dry etching may be physical etching that utilizes a sputtering phenomenon.

In the wet etching, an etchant may be supplied to the surface of the laminate having a coating film containing silicon atoms. Examples of the etchant include an etchant containing an oxidant such as ozone and an etchant containing an organic solvent. Examples of the organic solvent in the etchant containing an organic solvent include the organic solvents contained in the above-mentioned chemical liquid, among which a hydrocarbon-based solvent is preferable.

The coating film containing silicon atoms also preferably functions as a mask in a case of forming a metal-containing film by a chemical vapor deposition (CVD) method other than the ALD treatment. That is, in the CVD treatment, the deposition of a film by CVD (hereinafter, also referred to as a "CVD film") can be suppressed in the region where the coating film containing silicon atoms is formed, and the CVD film can be deposited in the region where the coating film containing silicon atoms is not formed. As described above, the coating film containing silicon atoms functions as a mask in the formation of the CVD film, so a laminate is obtained in which the CVD film is selectively formed in a region other than the region where the coating film containing silicon atoms is formed.

Examples of CVD other than ALD, which can be preferably applied to the above-mentioned modified substrate, include known techniques such as a thermal CVD method and a plasma CVD method. Examples of the raw materials for the CVD film used in the CVD treatment include the materials listed above as the raw materials for the ALD film. Examples

Hereinafter, the present invention will be described in more detail with reference to Examples.

The materials, the amounts and proportions of the materials used, the details of treatments, the procedure of treatments, and the like shown in the following Examples can be appropriately changed without departing from the scope and spirit of the present invention. Accordingly, the scope of the present invention should not be construed as being limited to the Examples described below.

It is noted that the preparation, filling, storage, and the like of the chemical liquid were all carried out in a clean room satisfying a level equal to or lower than ISO Class 2. In addition, the container used was cleaned with a solvent used for preparation or a prepared chemical liquid before use.

### [Preparation of chemical liquid]

The chemical liquids used in Examples and Comparative Examples were prepared by adding each component (silylation agent or specific silicon compound, alcohol, and water) to an aprotic solvent so as to have the contents shown in the table which will be given later. Hereinafter, the components used in preparing the chemical liquid will be described.

The aprotic solvent and alcohol used were of ultra-dehydrated grade.

[Silylation agent or specific silicon compound]
· Tetramethyl disilazane (TMDS)
· Hexamethyl disilazane (HMDS)
· Butyldimethyl(dimethylamino)silane
· Octadecyltrimethoxysilane

### [Aprotic solvent]

· Propylene carbonate
· Ethylene glycol dibutyl ether
· γ-Butyrolactone

### [Alcohol]

· Propylene glycol
· 1-Propanol
· 1-Pentanol
· 1-Octanol
· 2-Ethylhexanol
· Lauryl alcohol
· 1-Octadecanol
· Dipropylene glycol

The content of the alcohol in the chemical liquid was confirmed using a GC/MS device (GC/MS-QP2020, manufactured by Shimadzu Corporation). The measurement conditions are as follows.
Column: DB-Wax UI (length: 30 m, inner diameter: 0.25 mm, film thickness: 0.25 µm, manufactured by Agilent Technologies, Inc.)
Column temperature rising setting: 40°C (2 min) - 15°C/min - 250°C (6 min)
Injection liquid volume: 1 µL (250°C, split ratio: 1/50)
Flow rate: 1.11 mL/min
Detector: EI-MS (m/z 20-600)

The content of water (water content) in the chemical liquid was confirmed using a Karl Fischer device (trace moisture measuring device, CA-200, manufactured by Mitsubishi Chemical Analytech Co., Ltd.). Specifically, the amount of water vaporized from the sample was measured by an coulometric titration-heating vaporization method (vial method) using AQUAMICRON AX for an anodic solution and AQUAMICRON CXU for a cathodic solution. The heating temperature was set to 140°C.

### [Preparation of modified substrate]

According to the following procedure, a coating film was formed on a substrate using the chemical liquids of Examples and Comparative Examples.

A silicon oxide layer was formed by a CVD method on one surface of a commercially available silicon wafer (diameter: 12 inches) as a substrate having an insulator region. The treatment time of the CVD method was adjusted so that the film thickness of the silicon oxide layer was 100 nm.

The obtained wafer having a silicon oxide layer was cut into 2 cm square pieces. The cut wafer was immersed in a container filled with a 0.1% by mass hydrogen fluoride aqueous solution to carry out a pretreatment. The pretreatment was carried out while stirring the aqueous solution at a stirring speed of 250 rpm, and the temperature of the aqueous solution was set to 25°C and the immersion time was set to 1 minute. The wafer after the pretreatment was dried by blowing nitrogen gas onto the wafer.

Next, each wafer subjected to the pretreatment was immersed in each chemical liquid to form a coating film containing silicon atoms. The formation of the coating film was carried out while stirring the chemical liquid at a stirring speed of 250 rpm, the temperature of the chemical liquid was set to 25°C, and the immersion time was set to 10 minutes.

Finally, the obtained wafer was immersed in isopropyl alcohol (IPA) to carry out a rinsing treatment. The rinsing treatment was carried out while stirring IPA at a stirring speed of 250 rpm, and the temperature of IPA was set to 25°C and the rinsing time was set to 30 seconds. The wafer after the rinsing was dried by blowing nitrogen gas onto the wafer.

By the above procedure, a modified substrate on which a coating film containing silicon atoms was formed was obtained.

### [Evaluation]

### [Evaluation of contact angle]

The contact angle of water of the obtained modified substrate was measured by the following method.

Using a contact angle meter (DMS-501, manufactured by Kyowa Interface Science Co., Ltd.), the value of the contact angle 500 milliseconds after the liquid droplet of water comes into contact with the surface was measured three times, and the average value of the measured values was defined as the contact angle. The analysis was carried out with a surface tension of water being 72.9 mN/m. The measurement was carried out in an environment of 23°C.

### [Evaluation of deposition amount (film thickness)]

An aluminum oxide layer was formed on the obtained modified substrate by an atomic layer deposition (ALD) method using an ALD device (AD-230LP, manufactured by Samco Inc.). Trimethylaluminum was used as an organometallic raw material, water was used as an oxidant, and the ALD treatment temperature was set to 150°C. Other conditions were adjusted so that the film thickness was 5 nm.

The film thickness of the aluminum oxide layer of each sample after the ALD treatment was measured using a spectroscopic ellipsometer (M-2000XI, manufactured by J. A. Woollam Japan, Co., Inc.). The measurement was carried out at five points of the sample, and the average value of the measured values was defined as the film thickness. The measurement was carried out with a measurement range of 1.2 to 2.5 eV and a measurement angle of 70° and 75°.

It should be noted that the smaller the film thickness, the more difficult it is to deposit a film by the ALD treatment.

### [Results]

Table 1 shows the components of the chemical liquid and the evaluation results.

In the table, "wt%" means a % by mass concentration with respect to the total mass of the chemical liquid, and "ppm" means a ppm by mass concentration with respect to the total mass of the chemical liquid.

In the table, the content of the alcohol and the water content are values measured by the above-mentioned method.

The remainder of the chemical liquid, excluding a silylation agent or specific silicon compound, an alcohol, and water, is an aprotic solvent.

In the table, "Propylene carbonate/ethylene glycol dibutyl ether = 1/1" means that a mixed solvent of propylene carbonate and ethylene glycol dibutyl ether in a mass ratio of propylene carbonate/ethylene glycol dibutyl ether = 1/1 was used as the aprotic solvent, and "Propylene carbonate/γ-butyrolactone = 1/1" means that a mixed solvent of propylene carbonate and γ-butyrolactone in a mass ratio of propylene carbonate/γ-butyrolactone = 1/1 was used as the aprotic solvent.

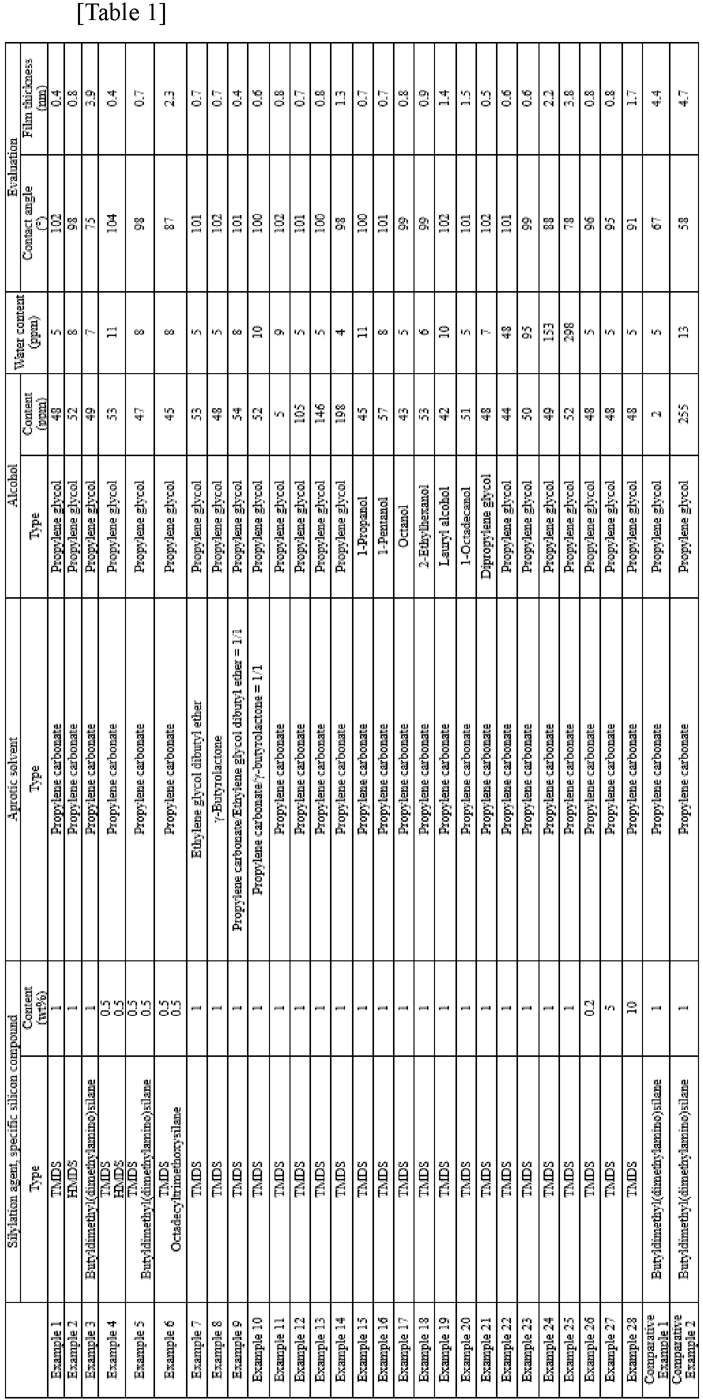

From the results in Table 1, it was confirmed that the chemical liquid according to the embodiment of the present invention can form a coating film in which the deposition of a material by an ALD treatment is suppressed.

From the results of Examples 1 to 6, it was confirmed that the effect of the present invention was more excellent in a case of a silazane compound.

From the results of Examples 1 and 7 to 10, it was confirmed that the effect of the present invention was more excellent in a case where the aprotic solvent was a carbonate solvent.

From the results of Examples 11 to 14, it was confirmed that the effect of the present invention was more excellent in a case where the content of the alcohol was 10 to 150 ppm by mass with respect to the total mass of the chemical liquid.

From the results of Examples 15 to 22, it was confirmed that the effect of the present invention was more excellent in a case where the alcohol had two or more hydroxyl groups.

From the results of Examples 15 to 22, it was confirmed that the effect of the present invention was more excellent in a case where the number of carbon atoms in the alcohol was 10 or less.

From the results of Examples 23 to 25, it was confirmed that the effect of the present invention was more excellent in a case where the content of water was 200 ppm by mass or less; the effect of the present invention was still more excellent in a case where the content of water was 100 ppm by mass or less; and the effect of the present invention was particularly excellent in a case where the content of water was 10 ppm by mass or less.

From the results of Examples 1 and 26 to 28, it was confirmed that the effect of the present invention was more excellent in a case where the content of the silylation agent or specific silicon compound was 0.1% to 5% by mass with respect to the total mass of the chemical liquid; and the effect of the present invention was still more excellent in a case where the content of the silylation agent or specific silicon compound was 0.3% to 3% by mass with respect to the total mass of the chemical liquid.

## Claims

1. A chemical liquid used for manufacturing a semiconductor, comprising:
a silylation agent;
an aprotic solvent; and
an alcohol,
wherein a content of the alcohol is 5 to 200 ppm by mass with respect to a total mass of the chemical liquid.

2. The chemical liquid according to claim 1,
wherein the silylation agent contains a compound having a Si-N bond.

3. The chemical liquid according to claim 1,
wherein the silylation agent contains a silazane compound or a compound represented by Formula (1), 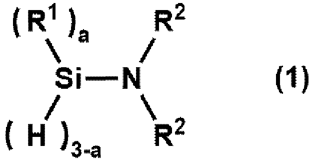
R¹'s each independently represent a hydrocarbon group which may have a halogen atom, R²'s each independently represent a hydrogen atom, a hydrocarbon group which may have a halogen atom, or an acyl group which may have a halogen atom, and a represents an integer of 1 to 3.

4. The chemical liquid according to claim **1,**
wherein the silylation agent contains a silazane compound.

5. The chemical liquid according to claim **1,**
wherein the chemical liquid further contains water, and
a content of the water is 100 ppm by mass or less with respect to the total mass of the chemical liquid.

6. The chemical liquid according to claim 1,
wherein the alcohol has 10 or less carbon atoms.

7. The chemical liquid according to claim 1,
wherein the alcohol has two or more hydroxyl groups.

8. The chemical liquid according to claim 1,
wherein the content of the alcohol is 5 to 150 ppm by mass with respect to the total mass of the chemical liquid.

9. A chemical liquid used for manufacturing a semiconductor, comprising:
a compound selected from the group consisting of a silazane compound, a compound represented by Formula (1), and an alkoxysilane compound;
an aprotic solvent; and
an alcohol,
wherein a content of the alcohol is 5 to 200 ppm by mass with respect to a total mass of the chemical liquid, 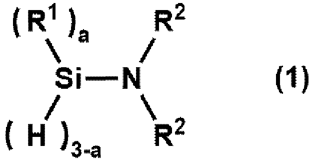
R¹'s each independently represent a hydrocarbon group which may have a halogen atom, R²'s each independently represent a hydrogen atom, a hydrocarbon group which may have a halogen atom, or an acyl group which may have a halogen atom, and a represents an integer of 1 to 3.

10. The chemical liquid according to claim 1,
wherein the chemical liquid is used in treating a substrate having, on a surface, at least two regions made of different materials.

11. A manufacturing method of a modified substrate, comprising:
a step 1 of bringing a substrate having a region made of an insulator into contact with the chemical liquid according to any one of claims 1 to 10 to form a coating film containing silicon atoms on the region made of the insulator.

12. The manufacturing method of a modified substrate according to claim 11,
wherein the insulator is a metal oxide.

13. The manufacturing method of a modified substrate according to claim 11, further comprising:
a step 2 of carrying out a rinsing treatment on the substrate having the coating film containing silicon atoms after the step 1.

14. A manufacturing method of a laminate, comprising:
a step 3 of subjecting a modified substrate manufactured by the manufacturing method according to claim 11 to an atomic layer deposition treatment to form a metal film, a metal oxide film, or a metal nitride film on a region other than a region where the coating film containing silicon atoms is formed.

15. The manufacturing method of a laminate according to claim 14, further comprising:
a step 4 of removing the coating film containing silicon atoms after the step 3.
